# EUROPEAN PATENT APPLICATION

(11) **EP 4 567 474 A1**
(43) Date of publication of application: **11.06.2025**
(21) Application number: 23215394.0
(22) Date of filing: 08.12.2023
(51) Int. Cl.: G01T 1/40, G01N 23/2251, H01J 37/28, G01T 1/17

(54) **SIGNAL PROCESSING METHOD, SIGNAL PROCESSOR, ASSESSMENT METHOD, AND ASSESSMENT APPARATUS**

(71) Applicant: ASML Netherlands B.V., 5500 AH Veldhoven (NL)
(72) Inventor: VAN LEEUWEN, Richard, Michel, 5500 AH Veldhoven (NL); KUIPER, Vincent, Sylvester, 5500 AH Veldhoven (NL)
(74) Representative: ASML Netherlands B.V.

(57) **Abstract**

A signal processing method comprising: receiving, from a detector, e.g. in a charged particle assessment apparatus, having a plurality of detector elements, a detection signal comprising a sequence of N ascending sample values for each detector element and for each sampling period, where N is an integer greater than 1; and outputting for each detector element and for each sampling period an output value;
wherein outputting comprises: selecting, for at least one detector element and at least one sampling period, the Nth sample value in the sequence of ascending sample values of that sample period as the output value; and determining, for at least one detector element and at least one sampling period, the output value on the basis of at least an Mth sample value in the sequence of ascending sample values of that sample period, where M is an integer less than N.

## Description

### FIELD

The present invention relates to signal processing methods and signal processing apparatus, especially such methods and apparatus usable in assessment methods and apparatus.

### BACKGROUND

During manufacturing processes of, for example, semiconductor integrated circuit (IC) chips or displays, undesired defects may occur on a substrate (e.g. wafer) or a mask. Such defects may reduce yield. Defects may occur as a consequence of all kinds of processing necessary to produce an integrated circuit or display, for example, lithography, etching, deposition or chemical mechanical polishing. Defects may include patterning defects, in which the created pattern lies outside the pattern tolerance for the process, and particles. Monitoring the extent of defects during the manufacturing processes is therefore important. Such monitoring includes the assessment of the existence of a defect, but also the assessment of the types of defects (classification of the defects) found.

For the assessment of defects (existence and/or classification), different types of inspection or metrology systems have been used, including charged particle systems such as electron microscopes. Electron microscopes typically generate a probe beam (also often referred to as primary beam) which may, for example, be scanned across a part of the substrate. Collecting interaction products that result from the interaction of the primary beam with the part of the substrate, allows the electron microscope to generate an image representation of the part of the substrate. The generated image representation allows for measuring structures on the part of the substrate (also further referred to as metrology), or allows for recognizing defective structures by comparing the image representation with a reference (also further referred to as inspection). The interaction products may contain signal electrons, such as secondary electrons and backscattered electrons, and may contain other interaction products, such as X-ray radiation.

Electron microscopes having multiple beams are proposed in order to increase the throughput of assessment apparatuses. A multi-beam apparatus may generate data at very high rates. Beam to beam differences and variations in detector sensitivity may be significant. It is therefore very difficult to simultaneously achieve a high throughput and a wide dynamic range without needing excessive bandwidth.

### SUMMARY

It is an aim of the invention to enable an increase in dynamic range without reducing throughput or increasing the amount of data that must be transmitted out of an assessment apparatus.

According to an aspect of the invention, there is provided a signal processing method comprising:
receiving, from a detector having a plurality of detector elements, a detection signal comprising a sequence of N ascending sample values for each detector element and for each sampling period, where N is an integer greater than 1; and
outputting for each detector element and for each sampling period an output value;
wherein outputting comprises:
selecting, for at least one detector element and at least one sampling period, the Nth sample value in the sequence of ascending sample values of that sample period as the output value; and
determining, for at least one detector element and at least one sampling period, the output value on the basis of at least an Mth sample value in the sequence of ascending sample values of that sample period, where M is an integer less than N.

According to an aspect of the invention, there is provided a method comprising:
directing a plurality of charged particle beams along respective beam paths towards respective sample locations;
detecting interaction products using a detector system having at least one detector element per charged particle beam and generating a detection signal comprising a sequence of N ascending sample values for each detector element and for each sampling period, where N is an integer greater than 1; and
processing the detection signal according to the method described above.

According to an aspect of the invention, there is provided a computer program comprising code means that, when executed by a computer system, instructs the computer system to perform a signal processing method as described above.

According to an aspect of the invention, there is provided a signal processor comprising:
an interface configured to receive, from a detector having a plurality of detector elements, a detection signal comprising a sequence of N ascending sample values for each detector element and for each sampling period, where N is an integer greater than 1; and
an output unit configured to output, for each detector element and for each sampling period an output value;
wherein the output unit comprises:
   a selector configured to select, for at least one detector element and at least one sampling period, the Nth sample value in the sequence of ascending sample values of that sample period as the output value; and
   a determination unit configured to determine, for at least one detector element and at least one sampling period, the output value on the basis of at least an Mth sample value in the sequence of ascending sample values of that sample period, where M is an integer less than N.

A charged particle-optical device configured to direct a plurality of charged particle beams along respective beam paths towards respective sample locations, the charged particle-optical device comprising a detector system having at least one detector element per charged particle beam and configured to generate a detection signal comprising a sequence of N ascending sample values for each detector element and for each sampling period, where N is an integer greater than 1; and the signal processor as described above.

### BRIEF DESCRIPTION OF THE DRAWINGS

Embodiments of the invention will now be described, by way of example only, with reference to the accompanying schematic drawings, in which:
- Figure 1 is a schematic diagram of an exemplary assessment apparatus;
- Figure 2 schematically depicts a multi-beam charged particle-optical device, for example of the assessment apparatus of Figure 1;
- Figure 3 schematically depicts a detector array in plan view;
- Figure 4 schematically depicts a detector element in cross-section;
- Figure 5 schematically depicts a datapath in an assessment apparatus;
- Figure 6 is a schematic diagram of a capacitive transimpedance amplifier;
- Figures 7 and 8 are graphs of outputs of a capacitive transimpedance amplifier with different reset timings;
- Figures 9 and 10 are graphs used to explain different modes of a signal processing method according to an embodiment of the invention; and
- Figure 11 is a flowchart of a signal processing method of an embodiment.

The Figures are schematic. Within the following description of drawings, the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred to with reference to electrons, throughout the present document may therefore be more generally be considered to be references to charged particles, and items referred to in reference to charged particles, with the charged particles not necessarily being electrons. For example, references to an electron-optical device may more generally be considered to be references to a charged particle-optical device.

### DETAILED DESCRIPTION

There is a trend in the semiconductor industry (often known as "Moore's law") to reduce the physical dimensions of structures representing circuit components on a substrate and/or to increase the packing density of such structures, in order to reduce the physical size of electronic devices and/or enhance the computing power of electronic devices. The physical dimensions of such structures may be reduced and/or the packing density of such structures may be increased by increasing lithographic resolution.

Manufacturing processes of semiconductor IC chips can have 100s of individual steps. An error in any step of the manufacturing process has the potential to adversely affect the functioning of the electronic device. It is desirable to improve the overall yield of the manufacturing process. For example, to obtain a 75% yield for a 50-step manufacturing process (where a step may indicate the number of layers formed on a substrate), each individual step must have a yield greater than 99.4%. If an individual step has a yield of 95%, the overall yield of the manufacturing process would be as low as 7-8%. It is desirable to determine defects quickly so as to maintain a high substrate throughput, defined as the number of substrates processed per hour.

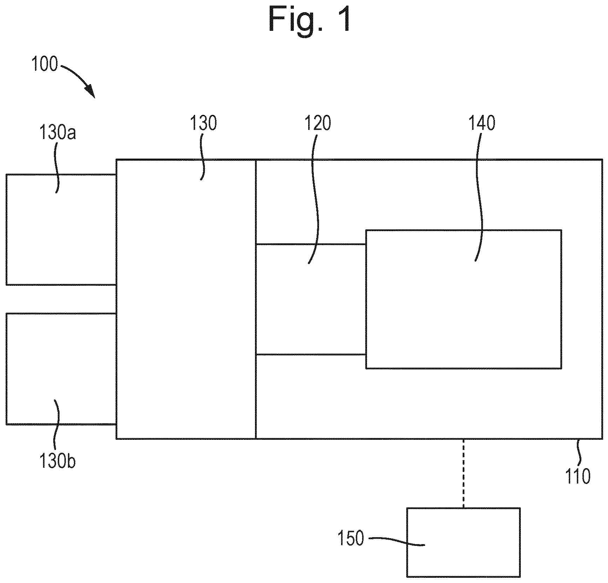

Figure 1 is a schematic diagram illustrating an exemplary assessment apparatus 100, e.g. a metrology apparatus or an inspection apparatus. The assessment apparatus 100 may be configured to scan a sample with one or more beams of electrons. The sample may be a semiconductor substrate, a substrate made of other material, or a mask, for example. The electrons interact with the sample and generate interaction products. The interaction products comprise signal electrons, e.g. secondary electrons and/or backscattered electrons, and possibly X-ray radiation. The assessment apparatus 100 may be configured to detect the interaction products from the sample so that an image of the scanned area of the sample can be generated. For clarity, the description below focuses on embodiments in which the interaction products that are detected are signal electrons. The assessment apparatus 100 may use a single beam or a plurality of beams, i.e. a multi-beam. The component beams of a multi-beam may be referred to as sub-beams or beamlets. A multi-beam may be used to scan different parts of a sample simultaneously. When the assessment apparatus 100 uses a multi-beam, the assessment apparatus 100 may assess a sample more quickly than when the assessment apparatus 100 uses a single-beam. For example, the sample may be moved at a higher speed.

The assessment apparatus 100 of Figure 1 comprises a vacuum chamber 110, a load lock chamber 120, an electron-optical apparatus 140, an equipment front end module (EFEM) 130 and a controller 150. The electron-optical apparatus 140 (also known as an electron beam apparatus or an electron apparatus) may be within the vacuum chamber 110. The electron-optical apparatus 140 may comprise an electron-optical device (described in more detail below) and an actuatable stage.

The EFEM 130 includes a first loading port 130a and a second loading port 130b. The EFEM 130 may include additional loading port(s). The first loading port 130a and the second loading port 130b may, for example, receive substrate front opening unified pods that contain samples. One or more robot arms (not shown) in the EFEM 130 transport the samples to the load lock chamber 120.

The load lock chamber 120 is used to remove the gas around a sample. The load lock chamber 120 may be connected to a load lock vacuum pump system (not shown), which removes gas particles in the load lock chamber 120. The operation of the load lock vacuum pump system enables the load lock chamber to reach a first pressure below the atmospheric pressure. The vacuum chamber 110, which may be a main chamber of the assessment apparatus 100, is connected to a main chamber vacuum pump system (not shown). The main chamber vacuum pump system removes gas molecules from the vacuum chamber 110 so that the pressure around the sample reaches a second pressure lower than the first pressure. After reaching the second pressure, the sample is transported to the electron-optical apparatus 140 by which it may be assessed. The electron-optical apparatus 140 may use either a single beam or a multi-beam. Alternatively, an electron-optical device array comprising a plurality of electron-optical devices may be used, each electron-optical device using either a single beam or a multi-beam.

The controller 150 is electronically connected to the electron-optical apparatus 140. The controller 150 may be a processor (such as a computer) configured to control the assessment apparatus 100. The controller 150 may also include processing circuitry configured to execute signal and image processing functions. While the controller 150 is shown in Figure 1 as being outside of the structure that includes the vacuum chamber 110, the load lock chamber 120, and the EFEM 130, it is appreciated that the controller 150 may be part of the structure. The controller 150 may be located in one of the components of the assessment apparatus 100 or it may be distributed over at least two of the components.

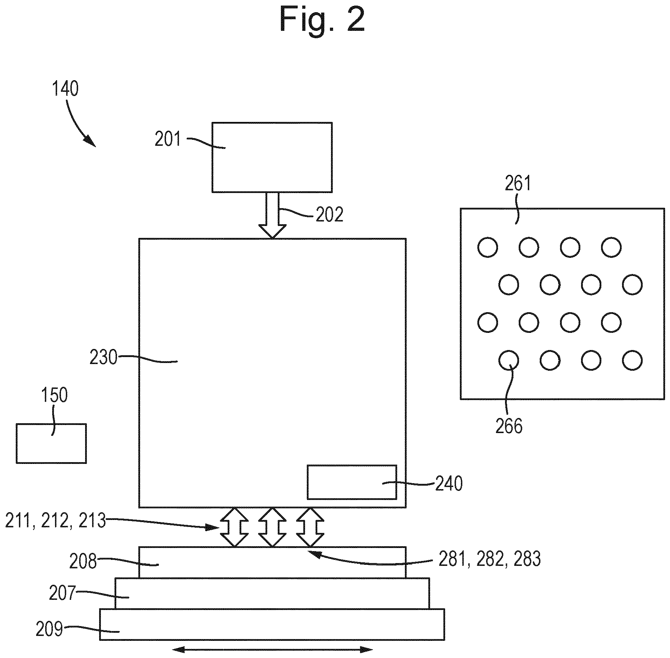

Figure 2 is a schematic diagram illustrating an exemplary electron-optical apparatus 140. The electron-optical apparatus 140 may be provided as part of the assessment apparatus 100 of Figure 1. The electron-optical apparatus 140 includes a source 201 and an electron-optical device 230 (which may also be referred to as an electron-optical column). The source 201 may comprise a cathode (not shown) and an extractor or anode (not shown). During operation, the source 201 is configured to emit electrons from the cathode. The electrons may be extracted or accelerated by the extractor and/or the anode to form the primary beam 202.

The electron-optical device 230 may be configured to convert the primary beam 202 into a plurality of beams 211, 212, 213 (which may be referred to as sub-beams or beamlets). The electron-optical device 230 may be configured to direct the beams 211, 212, 213 along respective beam paths toward a sample location for the sample 208. Although three beams are illustrated, the number of beams may be of the order of 100s or 1,000s, for example up to 20,000 per electron-optical apparatus 140. The plurality of beams may be referred to collectively as a multi-beam or a beam grid. The electron-optical device 230 has a field of view which may be defined as the area of the surface of the sample 208 within which the beams 211, 212, 213 can scan while the aberrations of the electron-optical device 230 remain within a defined value. Alternatively, the field of view may be defined by the maximum scan range of the electron-optical device 230. The field of view may be of the order of millimeters, for example up to 20mm at the sample 208.

The electron-optical device 230 comprises a plurality of electron-optical elements positioned along the beam paths. The electron-optical elements are configured to manipulate the beams. For example, the electron-optical elements may be configured to focus, deflect or correct the beams. The electron-optical elements may be arranged in at least one stack of electron-optical elements. Such an electron-optical element may be positioned upbeam or downbeam with respect to another of the electron-optical elements. The terms upbeam and downbeam relate to the direction of the beams from the source 201 to the sample 208 during use of the electron-optical device 230. In an embodiment some of the different electron-optical elements may take a planar form, such as a plate 261. An electric field that manipulates the beams may be generated between two plates 261. An electric field that manipulates the beams may be generated by electrodes along the thickness of the plates 261. One or more beam apertures 266 may be defined in the plates 261 for the passage of one or more beams. The beam apertures 266 may be arranged in a pattern such as a regular grid e.g. hexagonal or square. Beam apertures 266 in different plates operating on the same beam(s) are typically aligned.

The electron-optical elements may comprise one or more corrector arrays. For example, a corrector array may be integrated into the shape, position and/or size of the beam apertures 266 of the plates 261. The disclosure of such a corrector array as described in WO 2022101072 A1 is hereby incorporated by reference. One or more corrector arrays may comprise multipole deflectors with a specific superposition of potentials applied across the individually controllable electrodes. The disclosure in EP2715768A2 of an array of multipole deflectors is hereby incorporated by reference.

One or more of the electron-optical elements may comprise an aperture for the path of a plurality of the beams. For example, the aperture may be a macro aperture for all of the beams. The disclosures of a slit aperture for a collimator or corrector comprising strip electrodes in WO 2021156121 A1 and WO 2021204734 A1 are hereby incorporated by reference.

The electron-optical device 230 may form three probe spots 281, 282, 283 on the surface of the sample 208. The electron-optical device 230 may be configured to deflect the beams 211, 212, 213 so as to scan the probe spots 281, 282, 283 across individual scanning areas of the sample 208. In response to incidence of the beams 211, 212, 213 on the sample 208, signal electrons are generated from the sample 208 which may include secondary electrons and backscattered electrons. Secondary electrons typically have electron energy of at most 50 eV. Backscattered electrons typically have electron energy of more than 50 eV and less than the landing energy of the beams 211, 212, 213.

The electron-optical apparatus 140 comprises a sample holder 207 that supports a sample 208. The sample holder 207 supports the sample 208 for assessment. The sample holder 207 is supported by an actuatable stage 209. The electron-optical apparatus 140 further comprises a detector array 240. The detector array 240 may be part of the electron-optical device 230. The detector array 240 detects signal electrons from the sample 208. The detector array 240 generates detection signals based on detection of the signal electrons.

The detector array 240 may provide the surface of the electron-optical apparatus 140 facing the sample 208, e.g. the bottom surface of the electron-optical device 230. There may be more than one detector array at different positions along the paths of the beams 211, 212, 213.

The detector array 240 may comprise a plurality of detector elements, with at least one detector element per beam. The detector elements may, for example, be charge capture electrodes, for example metal plates, which may be configured to detect at least some of the signal electrons. Alternatively or additionally, the detector elements may comprise detection diodes configured to detect at least some of the signal electrons. Alternatively or additionally, the detector elements may comprise a scintillator material (such as YAG) configured to convert signal electrons into photons that may be subsequently detected. The detector elements may be arranged around beam apertures 266 in the bottom surface of the electron-optical device 230 to allow the beams 211, 212, 213 to pass towards the sample 208. Each detector element may comprise a plurality of detection segments or may constitute a single sensitive surface for each beam. The detection signal generated by a detector element may be transmitted to a processor for generation of an image. For example, the detection signal may represent a grey value or an intensity value of a pixel of an image.

The detector array 240 may send the detection signals, for example as an imaging signal or a detection signal, to the controller 150 or to a signal processing system (not shown) which may be part of the controller 150. The controller 150 or the signal processing system may be configured to generate images of the corresponding scanned areas of the sample 208. The detector array 240 may be incorporated at least partly into the electron-optical device 230. Alternatively, the detector array 240 may be separate from the electron-optical device 230. For example, the electron-optical apparatus 140 may comprise a secondary electron-optical device configured to direct secondary electrons to the detector array 240.

The controller 150 (for example a control system comprising distributed controllers) may be connected to various parts of the electron-optical apparatus 140 of Figure 2, such as the source 201, the detector array 240, the electron-optical device 230, and the actuatable stage 209. The controller 150 may perform various image processing functions and signal processing functions. The controller 150 may also generate various control signals to govern operations of the assessment apparatus 100.

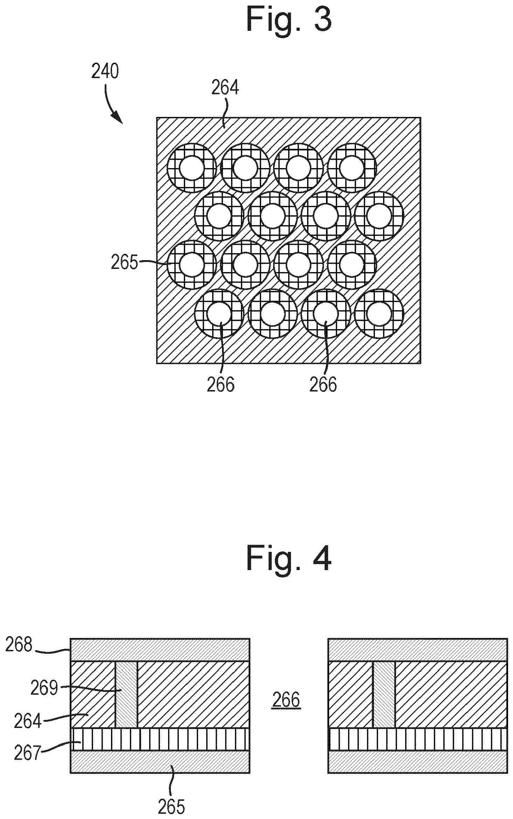

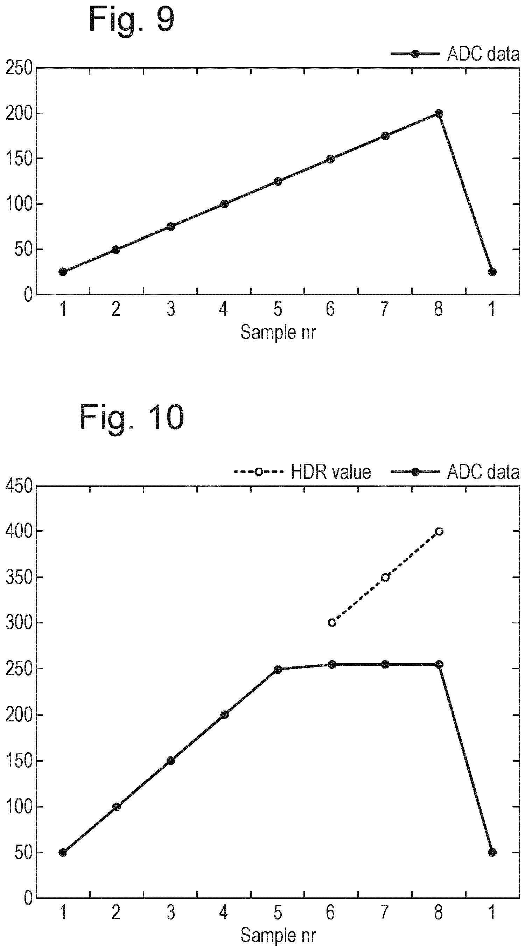

Figure 3 is a bottom view of the detector array 240 which comprises a detector substrate 264 on which are provided a plurality of detector elements 265 each surrounding a beam aperture 266. The detector array 240 may be provided at a downbeam surface of a plate 261 comprising beam apertures 266. The detector elements 265 are charge capture electrodes, for example metal plates. The beam apertures 266 may be formed by etching through the detector substrate 264. In the arrangement shown in Figure 10, the beam apertures 266 are in a hexagonal close packed array. The beam apertures 266 can also be differently arranged, e.g. in a rectangular array.

Figure 4 depicts at a larger scale a part of the detector array 240 in cross section. The detector elements 265 form the bottom surface, i.e. the surface the closest to the sample 208, of the detector array 240. Between the detector elements 265 and the main body of the detector substrate 264 a logic layer 267 may be provided. At least part of the signal processing system, for example for amplification, may be incorporated into the logic layer 267.

A wiring layer 268 is provided on the backside of, or within, the detector substrate 264 and connected to the logic layer 267 by through-substrate vias 269. The number of through-substrate vias 269 need not be the same as the number of beam apertures 266. In particular if the electrode signals are digitized in the logic layer 267 only a small number of through-silicon vias may be required to provide a data bus. The wiring layer 268 can include control lines, data lines and power lines. It will be noted that in spite of the beam apertures 266 there is ample space for all necessary connections. The detector array 240 can also be fabricated using bipolar or other manufacturing techniques. A printed circuit board and/or other semiconductor chips may be provided on the detector array 240.

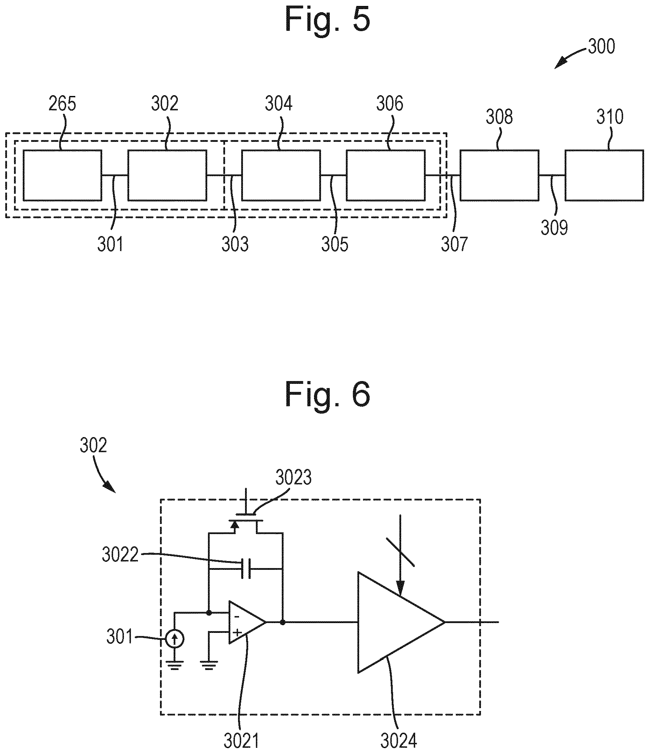

A datapath 300 of a detection subsystem is depicted in Figure 5. Detector elements 265, e.g. electron collecting elements, output respective analog signals 301 in response to interaction products resulting from the interaction of the electron beam and the sample at respective sample locations. For example, the analog signals may comprise current pulses whenever interaction products (e.g. electrons) are captured by the detector element. Amplifier circuits 302 receive the analog signals 301 and generate amplified analog signals 303. Amplifier circuits 302 may comprise trans-impedance amplifiers. The amplifier circuit 302 integrates the analog signals and converts them to voltage signals as the amplified analog signals.

A schematic of a suitable amplifier circuit is shown in Figure 6. The analog signal 301 from a detector element 265 is supplied to an operational amplifier (op-amp) 3021 which has a feedback capacitor 3022. A reset switch 3023 discharges the feedback capacitor in response to a reset signal. The output of op-amp 3021 is supplied to variable gain amplifier 3024. In operation, this circuit integrates the analog signal 301 until the reset signal is received. The output of the variable gain amplifier can be sampled at timings independent of the reset signal.

Analog to digital converters (ADCs) 304 receive the amplified analog signals 303 and generate sequences of digital sample values 305 at a predetermined frequency. A serial output circuit 306 receives the sequences of digital sample values 305 and combines them into a serial datastream 307 for onward transmission. A digital to optical transducer 308 modulates the serial datastream onto an optical signal 309 which is transmitted to external data processing devices via fibre feedthrough 310.

In the above arrangement, the amplifier circuits 302 are reset periodically to avoid saturation of the amplifier circuits 302 and/or the ADCs 304. The period between resets may be referred to as the sampling period. The sampling period can be longer than the interval between digital sample values 305, which interval may be referred to as the sub-sampling period. Desirably, the sampling period is substantially equal to an integer multiple of the sub-sampling period, allowing for a small time for the reset of the amplifier circuits.

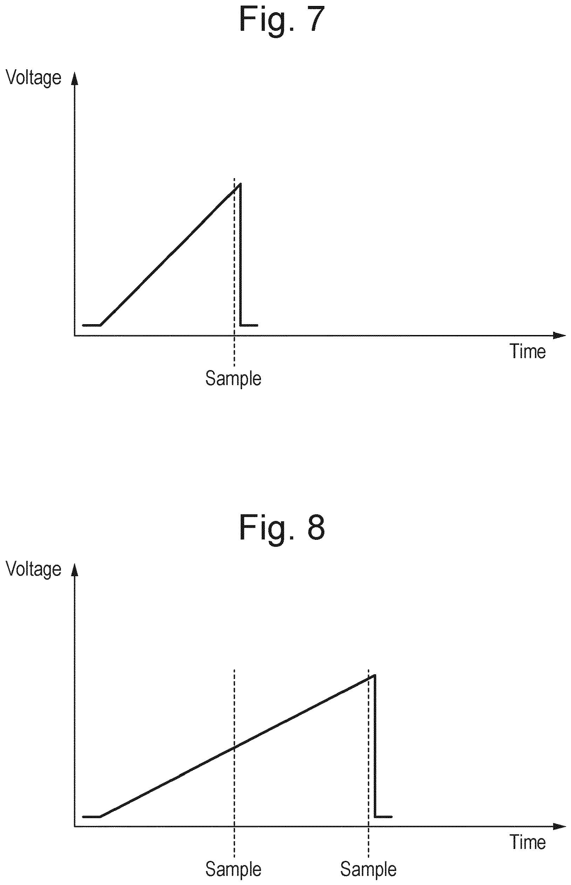

The length of the sampling period is a parameter that the user of the assessment apparatus may control - along with other parameters such: as beam current, scanning speed and amplifier gain - to control the exposure of the assessment apparatus. Other things being equal, increasing the sampling period increases the sensitivity of the exposure at the expense of resolution in the scanning direction. However, the scanning speed may be reduced proportionally to the increase of the sampling frequency so that sensitivity is increased at the expense of throughput. This can be seen in Figures 7 and 8 which depict the voltage output of the amplifier 302 over time. In Figure 7 the sampling period is substantially equal to the subsampling period and whereas in Figure 8 the sampling period is substantially twice the subsampling period. In the circumstances illustrated in Figure 8, the same output as in Figure 7 is reached at the end of the second subsampling period even though the slope of the voltage signal is half, representing a smaller signal from the sample.

In many cases, the user of the assessment apparatus will choose operating parameters that mean that the full range of possible output values of the ADCs are used, i.e. the maximum signal returned from the sample gives rise to the highest possible output value of the ADC, e.g. 255 for an 8-bit ADC. The output value of each ADC represents the combined effects of the parts of a channel from the beam source to the sample, to the detector and through the electronic circuits, including the property of the sample at the sample location which is to be measured. However, channel-to-channel differences, e.g. in beam current at the sample and/or in the gain of the amplifiers 302, mean that the maximum signal returned from the sample and at the output of the amplifier 302 can vary significantly, even as much as 20%. Accordingly, if the operating parameters are set to give maximum dynamic range for the average channel, some channels, e.g. which have higher than average beam current or amplifier gain, will saturate and information will be lost. Conversely if the operating parameters are set to prevent such "strong" channels from saturating then "weak" channels will have a lower effective dynamic range and information will be lost. Due, among other things, to limitations in the number of control signal paths that can be brought into the electron-optical device 230, it is not possible to adjust all operating parameters, e.g. amplifier gain, on a channel by channel basis. Also, the sampling period has to be the same for all channels otherwise there would be variations in the effective pixel size in the image of the sample that is obtained. A pixel is the output of one channel for one sampling period.

The present invention provides a solution that can avoid loss of information in many circumstances, in particular where the sample period is set to be equal to or longer than two subsampling periods. This is illustrated with reference to Figures 9 and 10 which relate to an exemplary embodiment where the ADCs have an 8-bit output (0-255 in decimal) and the sampling period is equal to 8 times the subsampling period.

During one sampling period, an ADC will generate a sequence of increasing sample values, 8 in this example. Conventionally, only the last sample value in each sequence is of interest; this represents the total accumulated charge during the sample period. Suppose, as depicted in Figure 9, the operating parameters are set such that the final sample value of a typical channel when the electron beam is on a bright spot on the sample is 200. Another "strong" channel may receive a larger current or have a higher gain such that the ADC reaches its maximum output value (e.g. 255) before the end of the sample period, e.g. at the 6^{th} sample value in the sequence, as depicted in Figure 10. This channel is said to be saturated and the maximum value may be referred to as the saturation value. Information is lost because such a channel may output a sequence of saturated pixels even where there is variation in the brightness of the sample.

According to the invention, it is proposed that, when saturation occurs in a given channel, rather than output the final sample value in a sequence of sample values as the pixel value, an output value is determined by a determination unit on the basis of one or more sample values prior to saturation in that sampling period. In other words, in a detection signal comprising sequences of N (N > 1) ascending sample values per detector element (channel), an output value is determined on the basis of at least the Mth sample value, where M < N. In particular, the one or more sample values prior to saturation can be used to predict the sample value that would have been obtained had the ADC had a sufficiently large dynamic range. In the example of Figure 10, it can be seen that the 1^{st} to 5^{th} sample values can be extrapolated to predict a sample value of 400, much greater than the saturation value, would have been obtained at the end of the sample period. In effect, the invention increases the dynamic range of the channel.

In a case where the current received by the detector element is substantially constant and so the sample values increase linearly, the output value can be determined as the Mth sample value multiplied by a factor N/M. In other cases a more complex calculation involving more than one sample value can be used. The calculation of the output value may include additional factors to account for any non-linearities in the channel.

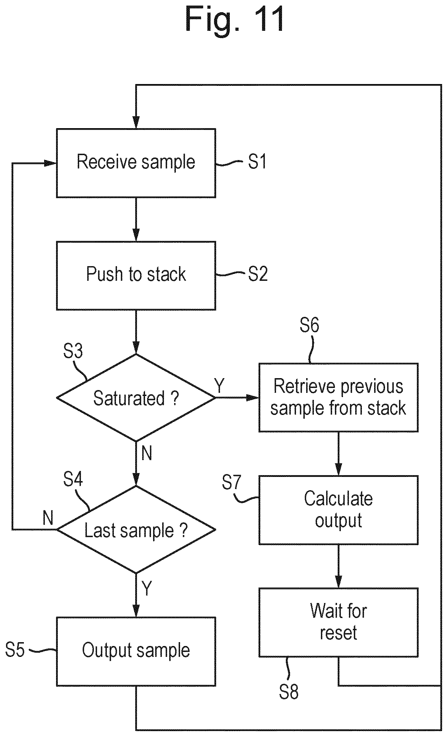

A flowchart of a signal processing method of an embodiment is depicted in Figure 11. A sequence of sample values are received one by one at step S1. The current sample value is pushed onto a stack at step S2. At step S3 it is checked if the current sample value is saturated. If not, it is checked at step S4 if the current sample value is the last in a sample period, prior to reset of the amplifier 302. If it is the last in the sequence, the current sample value is output as the output value (pixel value) for that channel and that sequence. The process then repeats. If at step S4, it is determined that the current sample value is not the last in a sequence of sample values, the process returns to step S1 to receive the next sample value and repeats. If at step S3 it is determined that the current sample value is saturated, e.g. by testing it against a threshold, the current sample value is discarded and the preceding sample value is retrieved from the stack at step S6. At step S7 an output value is determined from the preceding sample value and output. At step S8, the process waits for the reset denoting the end of the sample period and then the process repeats for the first sample value of the next sampling period.

It will be appreciated that methods in accordance with the invention, e.g. the above method, can be performed synchronously with the generation of data in the detector and with relatively simple logic. Therefore, the method of the invention can be performed close to the detector array 240, e.g. on circuitry embedded in the logic layer 267 of the detector array 240. In this way, the advantage of increased dynamic range can be achieved without significantly increasing the amount of data that must be transmitted out of the electron-optical column.

Of course variations of the above method are possible. For example, if it is known in advance which channels will saturate when assessing bright areas of the sample, e.g. because the amplifier gain is high, it is possible to determine in advance which channels will use the last sample value as output and which will calculate an output value from an earlier sample value. A calibration process to predetermine which sample value(s) will be used to calculate an output value for each channel may comprise scanning a calibration sample (sometimes referred to as a holy sample) having a known or uniform response to an incident electron beam. A calibration process may also or alternatively comprise analysis of output data obtained from assessment of production samples, e.g. by detecting channels that consistently saturate or saturate more frequently than average. In a multi-column apparatus (a charged particle assessment apparatus that has multiple electron optical devices) a calibration process may be used to determine which sample value(s) will be used to calculate an output value on a column-by-column basis rather than a channel-by-channel basis.

In another variation, the availability of a sequence of ascending sample values per detector element may be used to compensate for variations in the channels, especially variations in beam intensity. For example in a multi-beam system where a plurality of sub-beams are derived from a single primary beam, there may be variation in the intensity of the sub-beams. In particular the sub-beams that originate from the centre of the primary beam may be more intense than sub-beams that originate from nearer the edge of the primary beam. In a multi-column system having a separate electron source per column, the intensity of primary beams may differ between columns in addition to any variation between sub-beams within each column.

To compensate for variations in the channels, if, for a median channel the Mth sample value in the ascending sequence is selected, for a weak channel a later sample value (e.g. the Nth sample value where M < N) is selected and for a strong channel an earlier sample value (e.g. the Lth sample value, where L < M) is selected. Which sample value is selected depends on the relative strength of the channel. Considering a simple example, for a median (or reference) channel the 10^{th} sample value may be selected. In a strong channel where the beam power is approximately 111 % of the beam power of the reference channel, the 9^{th} sample value may be selected. The sampling time of the 9^{th} sample value is 9/10 of the sampling time of the 10^{th} sample value and so compensates for the extra power of the beam of the strong channel. Similarly, in a weak channel where the beam power is approximately 83% of the beam power of the reference channel, the 12^{th} sample value may be selected. The sampling time of the 12^{th} sample value is 12/10 of the sampling time of the 10^{th} sample value and so compensates for the lower power of the beam of the weak channel.

Several approaches to determining which sample value to use for each channel are possible. For example it is possible to measure the beam power in each channel in a calibration process. Alternatively, the beam power may be predicted on the basis of known characteristics, e.g. the position of the respective beam in an array or grid of sub-beams. A combination of approaches is also possible, for example some beam powers are measured and other beam powers interpolated or extrapolated from the measured beam powers.

In this variation, the samples that are selected for each detector element are treated equivalently, i.e. there is not the same scaling or extrapolation as used for saturating channels. However, since the number of sample values available is finite, a further adjustment to compensate more precisely for channel variations may be applied if desired. Also, it is possible to combine the approaches so as to both compensate for channel variations and provide an enhanced dynamic range.

It is also possible to transmit all sample values to a data processing device where they are stored and calculation of the output values may be performed asynchronously to the generation of the sample values. Asynchronous calculation may allow more complex calculations to be performed to derive the output value. Storage of all sample values may enable detailed analysis of the detector channels and calibration.

The sampling period may be set as a multiple N of the subsampling period, where N is in the range of from 1 to 64, for example, or more. If N is 1 the invention is not used.

The invention may be employed in all variants of charged particle assessment apparatus that have a plurality of detection elements, including charged particle assessment apparatus that have a large number of beams and one detection element per beam and apparatus that have multiple detection elements per beam. The invention may be employed in charged particle assessment apparatus that have multiple beams in a single electron optical device (or column) or that have multiple electron optical devices (or columns) each having multiple beams.

The invention may also be employed in assessment apparatus (e.g. metrology or inspection tools) that have detectors that detect particles (whether charged or not) and/or electromagnetic radiations (e.g. UV, DUV, EUV or x-rays). The invention may be employed in apparatus that use scintillators to detect particles and/or electromagnetic radiation.

Although specific reference may be made in this text to embodiments of the invention in the context of an electron microscope, embodiments of the invention may be used in other types of apparatus. Embodiments of the invention may form part of a mask inspection apparatus, a metrology apparatus, or any apparatus that measures or processes an object such as a wafer (or other substrate) or mask (or other patterning device).

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

Embodiments of the present invention are further described in the following numbered clauses:
1. A signal processing method comprising:
   receiving, from a detector comprising a plurality of detector elements, a detection signal comprising a sequence of N ascending sample values for each detector element and for each sampling period, where N is an integer greater than 1; and
   outputting for each detector element of the plurality of detector elements and for each sampling period an output value;
   wherein outputting comprises:
      selecting, for at least one detector element of the plurality of detector elements and at least one sampling period, the Nth sample value in the sequence of ascending sample values of that sample period as the output value; and
      determining, for at least one detector element of the plurality of detector elements and at least one sampling period, the output value on the basis of at least an Mth sample value in the sequence of ascending sample values of that sample period, where M is an integer less than N.
2. A method according to clause 1 wherein the output value is determined on the basis of at least an Mth sample value when at least the Nth sample value is at or above a threshold, desirably the threshold being a saturation value.
3. A method according to clause 1 wherein the output value is determined when at least the Nth sample value is at or above a threshold, desirably the threshold being a saturation value.
4. A method according to clause 2 or 3 wherein the Mth sample value is the largest sample value in the sequence that is smaller than the threshold.
5. A method according to clause 2, 3 or 4 wherein outputting comprises comparing the sample values of the sequence to the threshold and the selecting or determining is chosen based on the result of the comparison.
6. A method according to clause 1, 2, 3 or 4 wherein selecting or determining the output value is predetermined per detector element of the plurality of detector elements or group of detector elements of the plurality of detector elements.
7. A method according to any one of the preceding clauses wherein the determining comprises multiplying the Mth sample value by a factor N/M.
8. A method according to any one of clauses 1 to 6 wherein the determining comprises extrapolating the output value on the basis of a plurality of sample values including the Mth sample value.
9. A method according to clause 6 wherein the Mth sample value is used as the output value.
10. A method comprising:
   directing a plurality of charged particle beams along respective beam paths towards respective sample locations;
   detecting interaction products using a detector system having at least one detector element per charged particle beam and generating a detection signal comprising a sequence of N ascending sample values for detector elements of the detector system and for each sampling period, where N is an integer greater than 1; and
   processing the detection signal according to the method of any one of the preceding clauses.
11. A computer program comprising code that, when executed by a computer system, instructs the computer system to perform a method according to any one of clauses 1 to 9.
12. A signal processor comprising:
   an interface configured to receive, from a detector comprising a plurality of detector elements, a detection signal comprising a sequence of N ascending sample values for each detector element of the plurality of detector elements and for each sampling period, where N is an integer greater than 1; and
   an output unit configured to output, for each detector element of the plurality of detector elements and for each sampling period an output value;
   wherein the output unit comprises:
      a selector configured to select, for at least one detector element of the plurality of detector elements and at least one sampling period, the Nth sample value in the sequence of ascending sample values of that sample period as the output value; and
      a determination unit configured to determine, for at least one detector element of the plurality of detector elements and at least one sampling period, the output value on the basis of at least an Mth sample value in the sequence of ascending sample values of that sample period, where M is an integer less than N.
13. A processor according to clause 12 wherein the determination unit is configured to determine the output value when at least the Nth sample value is at or above a threshold, desirably the threshold being a saturation value.
14. A processor according to clause 13 wherein the determination unit is configured to determine the output value based the Mth sample value being the largest sample value in the sequence that is smaller than the threshold.
15. A processor according to clause 13 or 14 wherein the output unit is further configured to compare the sample values of the sequence to the threshold and to output the output value selected by the selection unit or determined by the determination unit based on the result of the comparison.
16. A processor according to clause 12, 13 or 14 wherein the output unit is further configured to output one of the output value selected by the selection unit or the output value determined by the determination unit that is predetermined per detector element.
17. A processor according to any one of clauses 12 to 16 wherein the determination unit is configured to calculate the output value by multiplying the Mth sample value by a factor N/M.
18. A processor according to any one of clauses 12 to 16 wherein the determination unit is configured to extrapolate the output value on the basis of a plurality of sample values including the Mth sample value.
19. A processor according to any one of clauses 12 to 16 wherein the determination unit is configured to select the Mth value as the output value.
20. A charged particle-optical device configured to direct a plurality of charged particle beams along respective beam paths towards respective sample locations, the charged particle-optical device comprising a detector system having at least one detector element per charged particle beam and configured to generate a detection signal comprising a sequence of N ascending sample values for detector elements of the detector system and for each sampling period, where N is an integer greater than 1; and the signal processor of any one of clauses 12 to 19.
21. An assessment apparatus comprising a detector system having a plurality of detector elements and configured to generate a detection signal comprising a sequence of N ascending sample values for each detector element and for each sampling period, where N is an integer greater than 1; and the signal processor of any one of clauses 12 to 19.
22. An assessment apparatus according to clause 21 wherein the detector elements are configured to detect particles and/or electromagnetic radiation.
23. A charged particle-optical device according to clause 19 wherein the signal processor is integrated into the detector.
24. A charged particle-optical device configured to direct a plurality of charged particle beams along respective beam paths towards respective sample locations, the charged particle-optical device comprising:
   a detector system having at least one detector element per charged particle beam and configured to generate a detection signal comprising a sequence of N ascending sample values for each detector element and for each sampling period, where N is an integer greater than 1; and
   a signal processor configured to select, for each detector element and each sampling period, a sample value in the sequence of ascending sample values of that sample period as an output value.
25. A charged particle-optical device according to clause 24 wherein the signal processor is configured such that the one of the sequence of N ascending sample values that is selected is predetermined per detector element, per charged particle beam or per group of charged particle beams.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

### List of reference numerals:

100 assessment apparatus
110 vacuum chamber (main chamber)
120 load lock chamber
125 beam limit aperture
130 EFEM
130a first loading port
130b second loading port
140 electron-optical apparatus (electron beam apparatus, electron apparatus)
150 controller
201 source
202 primary beam
207 sample holder
208 sample
209 actuatable stage
211, 212, 213 beams (sub-beams, beamlets)
230 electron-optical device (electron-optical column)
240 detector array
261 (aperture) plate
264 detector substrate
265 detector elements
266 beam apertures
267 logic layer
268 wiring layer
269 through-substrate vias
300 datapath
301 analog signal
302 amplifier circuit
303 amplified analog signal
304 analog to digital converter (ADC)
305 sequence of digital sample values
306 serial output circuit
307 datastream
308 digital to optical transducer
309 optical signal
310 fiber feedthrough
3021 OpAmp
3022 feedback capacitor
3023 reset switch
3024 gain controlled amplifier

## Claims

1. A signal processing method comprising:
receiving, from a detector comprising a plurality of detector elements, a detection signal comprising a sequence of N ascending sample values for each detector element and for each sampling period, where N is an integer greater than 1; and
outputting for each detector element of the plurality of detector elements and for each sampling period an output value;
wherein outputting comprises:
selecting, for at least one detector element of the plurality of detector elements and at least one sampling period, the Nth sample value in the sequence of ascending sample values of that sample period as the output value; and
determining, for at least one detector element of the plurality of detector elements and at least one sampling period, the output value on the basis of at least an Mth sample value in the sequence of ascending sample values of that sample period, where M is an integer less than N.

2. A method according to claim 1 wherein the output value is determined on the basis of at least an Mth sample value when at least the Nth sample value is at or above a threshold.

3. A method according to claim 2 wherein the Mth sample value is the largest sample value in the sequence that is smaller than the threshold.

4. A method according to claim 2 wherein outputting comprises comparing the sample values of the sequence to the threshold and the selecting or determining is chosen based on the result of the comparison.

5. A method according to claim 1 wherein selecting or determining the output value is predetermined per detector element of the plurality of detector elements or group of detector elements of the plurality of detector elements.

6. A method according to claim 1 wherein the determining comprises multiplying the Mth sample value by a factor N/M.

7. A method according to claim 1 wherein the determining comprises extrapolating the output value on the basis of a plurality of sample values including the Mth sample value.

8. A method according to claim 5 wherein the Mth sample value is used as the output value.

9. A method comprising:
directing a plurality of charged particle beams along respective beam paths towards respective sample locations;
detecting interaction products using a detector system having at least one detector element per charged particle beam and generating a detection signal comprising a sequence of N ascending sample values for detector elements of the detector system and for each sampling period, where N is an integer greater than 1; and
processing the detection signal according to the method of claim 1.

10. A computer program comprising code that, when executed by a computer system, instructs the computer system to perform a method according to claim 1.

11. A signal processor comprising:
an interface configured to receive, from a detector comprising a plurality of detector elements, a detection signal comprising a sequence of N ascending sample values for each detector element of the plurality of detector elements and for each sampling period, where N is an integer greater than 1; and
an output unit configured to output, for each detector element of the plurality of detector elements and for each sampling period an output value;
wherein the output unit comprises:
a selector configured to select, for at least one detector element of the plurality of detector elements and at least one sampling period, the Nth sample value in the sequence of ascending sample values of that sample period as the output value; and
a determination unit configured to determine, for at least one detector element of the plurality of detector elements and at least one sampling period, the output value on the basis of at least an Mth sample value in the sequence of ascending sample values of that sample period, where M is an integer less than N.

12. A processor according to claim 11 wherein the determination unit is configured to determine the output value when at least the Nth sample value is at or above a threshold.

13. A processor according to claim 12 wherein the output unit is further configured to compare the sample values of the sequence to the threshold and to output the output value selected by the selection unit or determined by the determination unit based on the result of the comparison.

14. A processor according to claim 11 wherein the determination unit is configured to calculate the output value by multiplying the Mth sample value by a factor N/M, or wherein the determination unit is configured to extrapolate the output value on the basis of a plurality of sample values including the Mth sample value.

15. A charged particle-optical device configured to direct a plurality of charged particle beams along respective beam paths towards respective sample locations, the charged particle-optical device comprising a detector system having at least one detector element per charged particle beam and configured to generate a detection signal comprising a sequence of N ascending sample values for detector elements of the detector system and for each sampling period, where N is an integer greater than 1; and the signal processor of claim 11.
